# DEMANDE DE BREVET EUROPEEN

(11) **EP 2 299 491 A2**
(43) Date de publication de la demande: **23.03.2011**
(21) Numéro de dépôt: 10176393.6
(22) Date de dépôt: 13.09.2010
(51) Int. Cl.: H01L 27/146

(54) **Dispositif d'imagerie 3d et procede de fabrication associe**

(30) Priorité: 17.09.2009 FR 0956383
(71) Demandeur: Commissariat à l'Énergie Atomique et aux Énergies Alternatives, 75015 Paris (FR)
(72) Inventeur: Getin, Stéphane, 38100 Grenoble (FR); Ferret, Pierre, 38000 Grenoble (FR); Nicoletti, Sergio, 38650 Sinard (FR)
(74) Mandataire: Ilgart, Jean-Christophe

(57) **Abrégé**

L'invention concerne un dispositif d'imagerie 3D comprenant une matrice (M) de photodétecteurs (2), une couche de matériau (1) fixée sur une face de la matrice de photodétecteurs, la couche de matériau (1) étant apte à réfléchir ou absorber la lumière, une ouverture (3) étant pratiquée dans ladite couche de matériau au niveau de chaque photodétecteur (2), une couche de matériau isolant (6) fixée sur ladite couche de matériau (1) apte à réfléchir ou absorber la lumière, la couche de matériau isolant (6) ayant une face enrobant, dans sa masse, un ensemble de guides d'onde (5), chaque guide d'onde (5) de l'ensemble de guides d'onde étant positionné verticalement par rapport à ladite face, en regard d'une ouverture (3), les hauteurs des différents guides d'onde, prises par rapport à la face de la couche de matériau isolant, définissant N niveaux distincts, N étant un nombre entier supérieur ou égal à 2.

## Description

### Domaine technique et art antérieur

L'invention concerne un dispositif d'imagerie 3D (3D pour « à trois dimensions ») ainsi qu'un procédé de fabrication de dispositif d'imagerie 3D.

L'invention concerne également un système d'imagerie 3D qui comprend un élément apte à former une image en volume d'un objet tridimensionnel et un dispositif d'imagerie 3D selon l'invention.

L'invention trouve une application dans de nombreux domaines comme, par exemple, les équipements pour le cinéma et la télévision, les appareils photographiques, la télésurveillance, la télémétrie, l'imagerie biologique et médicale, etc.

Plusieurs méthodes sont connues de l'art antérieur pour faire de l'imagerie 3D.

La plus connue de ces méthodes est la stéréoscopie. La stéréoscopie repose sur l'utilisation de deux systèmes d'imagerie identiques légèrement décalés dans l'espace, chaque système d'imagerie délivrant une image de la scène observée. L'image 3D est alors construite à partir des deux images délivrées par les systèmes d'imagerie. L'inconvénient de la stéréoscopie est la nécessité qu'il y a à utiliser deux capteurs. Les deux capteurs constituent en effet un ensemble encombrant dont les positions respectives s'avèrent délicates à étalonner.

Pour pallier l'inconvénient d'une utilisation de deux capteurs, une méthode connue, l'autostéréoscopie, consiste à réaliser une image 3D à l'aide d'un seul capteur constitué d'une matrice de détecteurs équipée de microlentilles, la matrice de détecteurs équipée de microlentilles étant elle-même entièrement recouverte par une lentille placée dans un support. L'inconvénient d'un tel capteur réside dans l'assemblage délicat des différents éléments qui le constituent.

Une autre méthode est basée sur l'utilisation de la profondeur de champ de lentilles. Le principe de la méthode consiste à faire varier la position du plan image d'une lentille afin de résoudre un objet à étudier en profondeur. A cette fin, on déplace la lentille et on recompose les différents plans images de l'objet. Un inconvénient de cette méthode est une grande complexité de mise en oeuvre.

Le dispositif d'imagerie 3D de l'invention ne présente pas les inconvénients des dispositifs de l'art antérieur mentionnés ci-dessus.

### Exposé de l'invention

En effet, l'invention concerne un dispositif d'imagerie 3D comprenant une matrice de photodétecteurs, **caractérisé en ce qu**'il comprend :
- une première couche de matériau fixée sur une face de la matrice de photodétecteurs, la première couche de matériau étant apte à réfléchir ou absorber une lumière qui est incidente sur une quelconque de ses faces, une ouverture étant pratiquée dans la première couche de matériau au niveau de chaque photodétecteur, et
- une deuxième couche de matériau, faite en matériau électriquement isolant, ayant une première face fixée sur la première couche de matériau, la deuxième couche de matériau enrobant, dans sa masse, un ensemble de G guides d'onde, G étant un entier supérieur ou égal à 2, chaque guide d'onde de l'ensemble de G guides d'onde ayant une première extrémité affleurant sensiblement la première face de la deuxième couche de matériau et étant positionnée sensiblement en regard d'une ouverture et une deuxième extrémité affleurant sensiblement une deuxième face de la deuxième couche de matériau opposée à la première face, chaque deuxième extrémité formant un élément de capture pour une lumière incidente sur la deuxième face de la deuxième couche de matériau, les distances qui séparent les premières extrémités des deuxièmes extrémités de N guides d'ondes distincts, N étant un nombre entier supérieur ou égal à 2 et inférieur ou égal à G, étant différentes les unes des autres.

Par « couche de matériau apte à réfléchir ou absorber une lumière sur une quelconque de ses faces », il faut entendre une couche de matériau qui bloque par réflexion et/ou par absorption la transmission d'une lumière qui est incidente sur l'une quelconque de ses faces.

Par « deuxième extrémité formant un élément de capture pour une fraction d'une lumière incidente sur la deuxième face de la deuxième couche de matériau », il faut entendre que la deuxième extrémité d'un guide d'onde constitue l'entrée d'un guide par laquelle la fraction de lumière incidente est couplée dans le guide.

Selon le mode de réalisation préférentiel de l'invention, les guides d'onde sont des nanofils formés par croissance à partir de plots métalliques. L'invention concerne cependant d'autres types de guides d'onde formés par d'autres techniques connues de la microélectronique, comme, par exemple, l'échange d'ions ou la gravure d'une couche remplie par un matériau dont l'indice de réfraction est supérieur à celui de la couche (par exemple à l'aide un procédé de type CVD ou dépôt chimique en phase vapeur).

Selon encore une autre caractéristique supplémentaire de l'invention, les G guides d'onde sont distribués au-dessus de la face de la matrice de photodétecteurs de manière que Nd guides d'onde d'au moins un ensemble de Nd guides d'onde respectivement situés en regard de Nd ouvertures pratiquées au niveau de Nd photodétecteurs voisins formant une sous-matrice élémentaire de P lignes et Q colonnes, P et Q étant des entiers supérieurs ou égaux à 2 (P x Q = Nd), Nd étant un nombre supérieur ou égal à N, présentent N hauteurs distinctes prises par rapport à la première face de la deuxième couche de matériau.

Selon encore une autre caractéristique supplémentaire de l'invention, lorsque la matrice de photodétecteurs comprend plusieurs ensembles distincts de Nd guides d'onde, les Nd guides d'onde de chaque ensemble de Nd guides d'onde sont distribués selon un motif identique d'un ensemble de Nd guides d'onde à l'autre.

L'invention concerne également un procédé de fabrication de dispositif d'imagerie 3D, **caractérisé en ce qu**'il comprend :
- une étape de formation d'une première structure constituée d'une matrice de photodétecteurs sur une face de laquelle est déposée une première couche de matériau apte à réfléchir ou absorber une lumière incidente sur une quelconque de ses faces, une ouverture étant pratiquée dans la première couche de matériau au niveau de chaque photodétecteur,
- une étape de formation d'une deuxième structure constituée d'un substrat de type silicium sur isolant sur lequel sont fixés des nanofils enrobés dans une deuxième couche de matériau électriquement isolant, les nanofils étant répartis sur le substrat de type silicium sur isolant de façon sensiblement identique à la façon dont sont répartis les ouvertures pratiquées dans la première couche de matériau de la première structure et affleurant une surface plane de la couche de matériau,
- une étape de report de la deuxième structure sur la première structure de sorte que les extrémités des nanofils qui affleurent la face plane de la deuxième couche de matériau soient placés en regard desdites ouvertures, et
- une étape de gravure du substrat de type silicium sur isolant et de la couche de matériau dans laquelle sont enrobés les nanofils pour, tout d'abord, supprimer le substrat de type silicium sur isolant puis, former N niveaux distincts de la deuxième couche de matériau dans laquelle sont enrobés les nanofils, les N niveaux distincts permettant de définir, respectivement, N nanofils distincts ayant des hauteurs différentes les unes des autres, N étant un nombre entier supérieur ou égal à 2.

Selon une caractéristique supplémentaire du procédé de l'invention, l'étape de formation de la première structure comprend :
- une étape de dépôt, sur la face de la matrice de photodétecteurs, de la première couche de matériau, et
- une étape de gravure de la première couche de matériau pour former les ouvertures pratiquée au niveau des photodétecteurs.

Selon encore une autre caractéristique supplémentaire de l'invention, l'étape de formation de la deuxième structure comprend :
- une étape de dépôt, sur le substrat de type silicium sur isolant, d'une couche métallique,
- une étape de gravure de la couche métallique pour former un ensemble de plots métalliques répartis, sur le substrat de type silicium sur isolant, d'une façon sensiblement identique à la façon dont sont répartis les ouvertures sur la matrice de photodétecteurs,
- une étape de croissance de nanofils à partir des plots métalliques,
- une étape de dépôt de la deuxième couche de matériau sur le substrat de type silicium sur isolant de façon à enrober l'ensemble des nanofils, et
- une étape de planarisation de la deuxième couche de matériau pour supprimer les plots métalliques et rendre plane la surface de la deuxième couche de telle sorte que les nanofils affleurent ladite surface.

L'invention concerne également un système d'imagerie 3D comprenant un élément apte à former une image en volume d'un objet tridimensionnel, **caractérisé en ce qu**'il comprend, en outre, un dispositif d'imagerie 3D selon l'invention qui est placé au niveau de l'image en volume.

### Brève description des figures

D'autres caractéristiques et avantages de l'invention apparaîtront à la lumière de la description qui va suivre, faite en référence aux figures jointes parmi lesquelles :
- les figures 1-7 représentent des étapes successives du procédé de fabrication d'un dispositif d'imagerie 3D selon le mode de réalisation préférentiel de l'invention ; et
- la figure 8 illustre un fonctionnement de dispositif d'imagerie 3D de l'invention ;
- la figure 9 représente un exemple de système d'imagerie 3D selon l'invention.

Sur toutes les figures, les mêmes références désignent les mêmes éléments.

### Exposé détaillé de modes de réalisation de l'invention

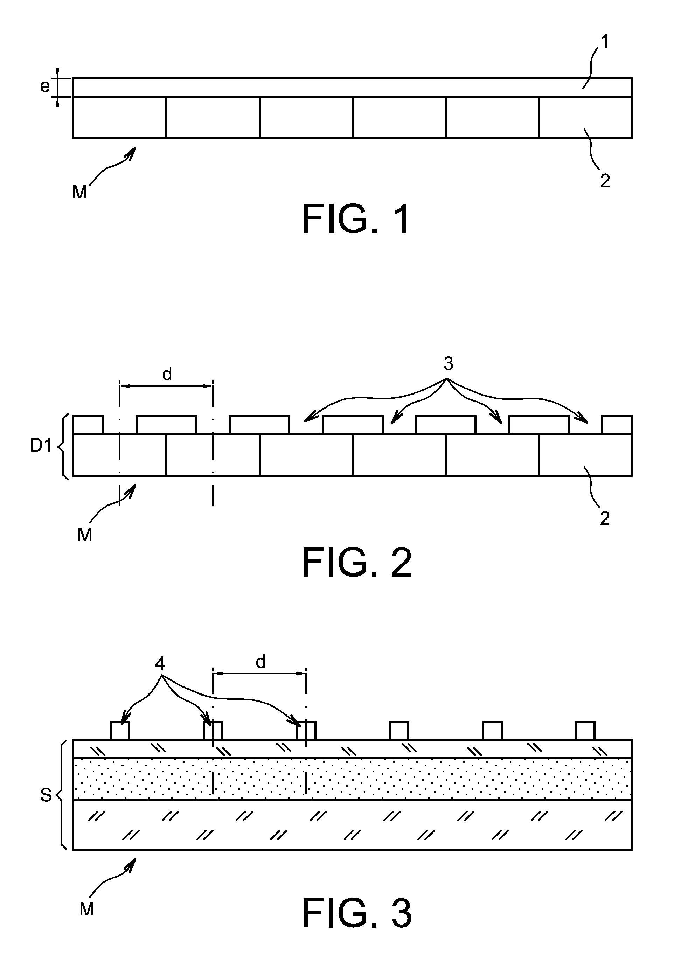

Les figures 1-7 représentent les étapes successives d'un procédé de fabrication de dispositif d'imagerie 3D selon le mode de réalisation préférentiel de l'invention pour lequel les guides d'onde sont des nanofils.

La figure 1 représente une première étape du procédé de fabrication de dispositif d'imagerie 3D selon le mode de réalisation préférentiel de l'invention.

La première étape du procédé de fabrication consiste à déposer une couche 1 de matériau apte à réfléchir ou absorber une lumière incidente, par exemple une couche d'aluminium, sur une matrice M de photodétecteurs 2. Les photodétecteurs 2 sont, par exemple, des jonctions P/N formées dans du silicium, des dispositifs à transfert de charges plus connus sous l'appellation de dispositifs CCD (CCD pour « Charge Couple Devices »), des bolomètres, etc. L'épaisseur e de la couche 1 est, par exemple, égale à 100nm.

La couche 1 est ensuite gravée, de façon connue en soi, pour former, au dessus de chaque photodétecteur 2, une ouverture 3 dont les dimensions sont, par exemple, égales à 150nm x 150nm (cf. figure 2). Une distance d, par exemple égale 5 µm, sépare les deux ouvertures formées au dessus de deux photodétecteurs voisins. Un premier dispositif D1 est alors constitué.

Une troisième étape consiste à former un ensemble de plots métalliques sur un substrat de type silicium sur isolant, plus communément appelé substrat SOI (SOI pour «Silicon On Insulator »). La figure 3 illustre cette troisième étape. Une couche métallique, par exemple une couche d'or, est déposée sur un substrat SOI S formé par la superposition d'un substrat de silicium Si, d'une couche d'isolant SiO₂ et d'une couche mince de silicium Si. La couche métallique est ensuite gravée, de façon connue en soi, pour former des plots 4. Les plots 4 sont répartis à la surface du substrat SOI d'une façon sensiblement identique à celle avec laquelle sont réparties les ouvertures 3 pratiquées dans la couche d'aluminium à l'étape 2 précédente. Ainsi, deux plots voisins 4 sont-ils séparés, d'axe à axe (cf. figure 3), par une distance sensiblement égale à la distance d qui sépare, d'axe à axe, deux ouvertures voisines 3 (cf. figure 2). La section transversale d'un plot 4 est choisie pour s'inscrire dans la surface d'une ouverture. Ainsi, pour des ouvertures 3 de dimensions 150nm x 150nm, la section transversale d'un plot 4 est-elle, par exemple, égale à 100nm.

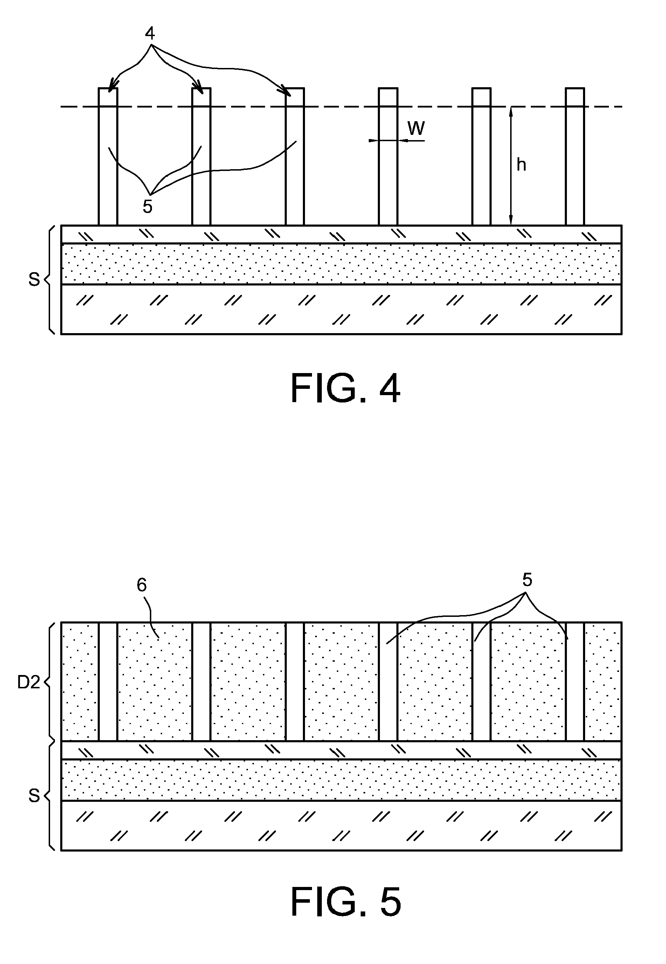

Une étape de croissance de nanofils succède à la formation des plots 4 sur le substrat SOI. L'étape de croissance des nanofils s'effectue, de façon connue en soi, par un procédé VLS (VLS pour « Vapeur Liquide Solide »). La figure 4 illustre le résultat de l'étape de croissance des nanofils. La hauteur h des nanofils 5 est préférentiellement comprise entre 100nm et 100µm (par exemple, 50µm) et leur diamètre W préférentiellement compris entre 50nm et 3µm. Le matériau qui constitue les nanofils est, par exemple, de l'oxyde de Zinc (ZnO), ou du silicium (Si), ou du nitrure de Gallium (GaN), etc.

Une fois les nanofils réalisés, une couche 6 de matériau électriquement isolant, par exemple une couche de SiO₂, est déposée sur la couche de silicium du substrat SOI (cf. Figure 5). La couche 6 est caractérisée par sa faible absorption dans la gamme de longueurs d'onde dans laquelle opère le système (typiquement un matériau de type diélectrique). On entend par faible absorption un matériau dont la valeur absolue de la partie imaginaire de l'indice de réfraction est inférieure à 0,01.

Les nanofils 5 sont alors enrobés dans la couche de matériau électriquement isolant 6. Un polissage mécano-chimique, ou planarisation, est effectué sur la couche 6 de façon à supprimer les plots 4 et à rendre plane la surface de la couche. Les extrémités des nanofils affleurent alors la surface de la couche 6. Un deuxième dispositif D2 est ainsi constitué.

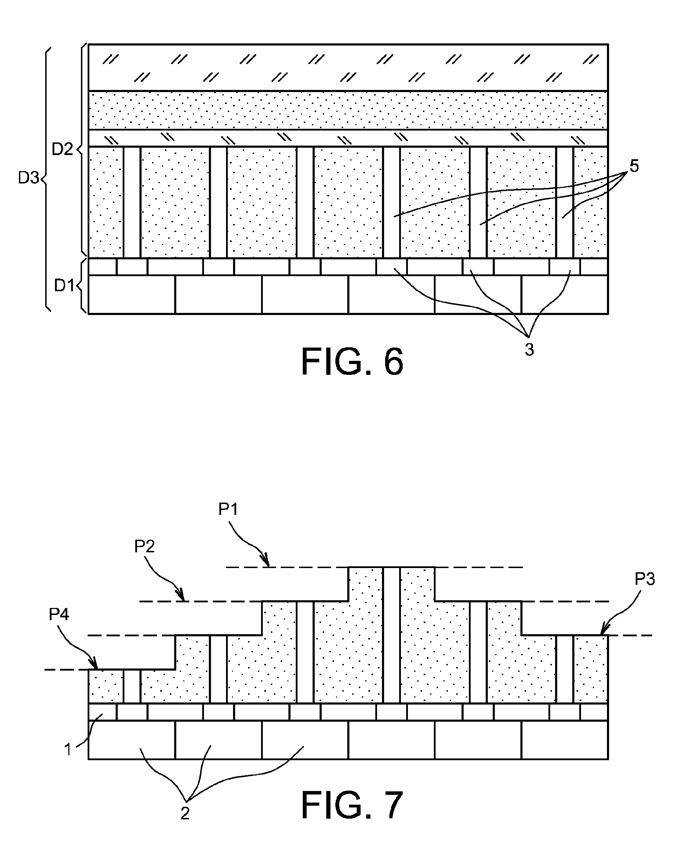

Les deux dispositifs D1 et D2 obtenus à l'issue des étapes décrites ci-dessus (cf. le dispositif représenté en figure 2 et le dispositif représenté en figure 5) sont ensuite assemblés de telle sorte que les extrémités des nanofils 5 qui affleurent la surface de la couche 6 sont placées en regard des ouvertures 3, un nanofil 5 étant sensiblement centré par rapport à une ouverture 3 (cf. figure 6). L'assemblage des dispositifs D1 et D2 s'effectue de façon connue en soi, par exemple à l'aide d'une colle transparente à la longueur d'onde utilisée. Le dispositif D3 qui résulte de l'assemblage des dispositifs D1 et D2 est ensuite gravé. Lors de cette gravure, le substrat SOI est supprimé et le bloc constitué par les nanofils 5 et la couche isolante 6 qui enrobe les nanofils est gravé sur N niveaux distincts, N étant un nombre entier préférentiellement compris entre 10 et 20 (le nombre entier N pouvant toutefois prendre toute autre valeur comprise entre 2 et 10 ou supérieure à 20, selon le besoin). Sur la figure 7, le nombre N de niveaux est, par exemple, égal à 4. Les N niveaux peuvent être ou non uniformément répartis entre le premier niveau (niveau de rang 1) et le Nième niveau (niveau de rang N). Les N niveaux de la couche isolante 6 constituent ainsi N niveaux de capture distincts pour une lumière qui est incidente sur la couche isolante 6. Les N niveaux peuvent être distribués, par exemple, sur une profondeur égale à 500 µm. A titre d'exemple non limitatif en référence à la figure 7, quatre plans parallèles P1, P2, P3, P4 représentent quatre niveaux de capture distincts..

Dans un premier mode de réalisation de l'invention, la hauteur des différents niveaux (i.e. la hauteur des nanofils) est distribuée de façon aléatoire. Le masque utilisé pour la gravure du dispositif D3 est alors conçu à cette fin.

Dans un deuxième mode de réalisation de l'invention, les photodétecteurs sont regroupés par blocs de photodétecteurs ou sous-matrices élémentaires. Une sous-matrice élémentaire comprend alors Nd photodétecteurs distribués sur P lignes et Q colonnes, P et Q étant des entiers supérieurs ou égaux à 2 (PxQ=Nd), Nd étant un nombre supérieur ou égal à N. Les hauteurs des Nd nano-fils associés aux Nd photodétecteurs de chaque sous-matrice élémentaire définissent alors les N plans de détection parallèles distincts.

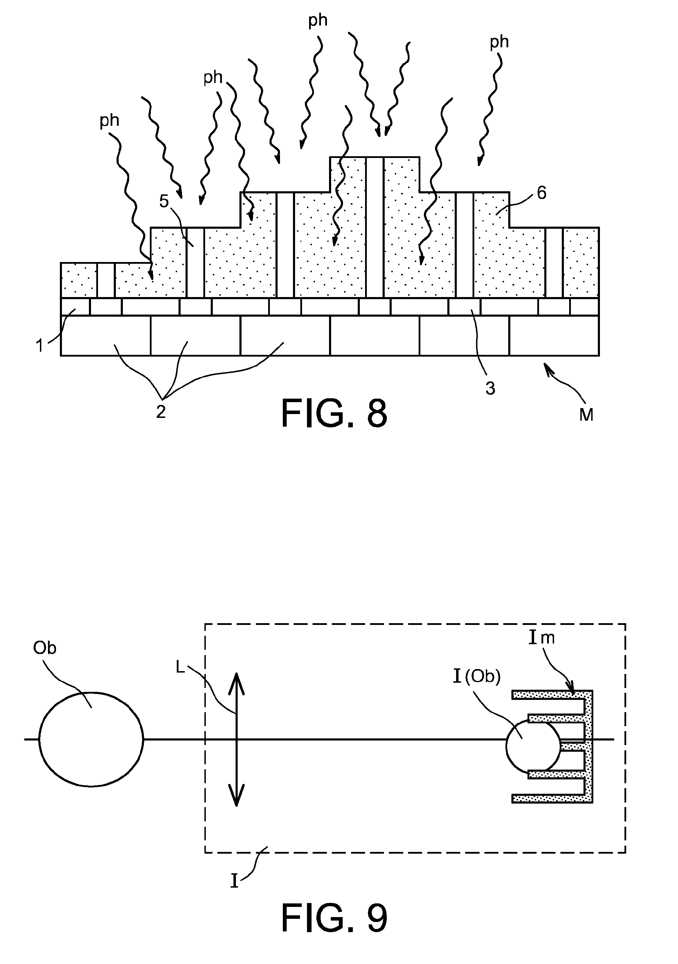

La figure 8 illustre un fonctionnement du dispositif d'imagerie représenté en figure 7. Un détecteur élémentaire du dispositif d'imagerie est constitué d'un photodétecteur 2 et du nanofil 5 situé directement au-dessus du photodétecteur 2. La couche 1 de matériau apte à réfléchir ou à absorber la lumière empêche que celle-ci n'atteigne directement les photodétecteurs. Chaque extrémité d'un nanofil 5 qui affleure la surface de la couche de matériau isolant 6 est un élément de capture pour une fraction de la lumière qui est incidente sur la couche 6. Chaque nanofil 5 constitue ainsi un guide d'onde dans lequel se propage la lumière qui est captée. Les photons ph qui atteignent un photodétecteur 2 ne sont alors que ceux qui se propagent dans le nanofil 5 situé directement au-dessus du photodétecteur 2. La longueur d'un guide d'onde (i.e. la hauteur d'un nano-fil) détermine un plan sur lequel est faite la coupe d'une fraction de l'image.

Avant utilisation du dispositif d'imagerie, une étape de calibration durant laquelle est formée une image d'un objet de dimensions connues placé à une distance connue du dispositif d'imagerie permet avantageusement de déterminer la profondeur susceptible d'être détectée, photodétecteur par photodétecteur, par le dispositif d'imagerie de l'invention. Les résultats de la calibration peuvent avantageusement être mis en mémoire et utilisés, ultérieurement, pour déterminer la position d'un objet quelconque qui est imagé. Il a été constaté que, grâce aux nanofils, le dispositif d'imagerie de l'invention est très sélectif pour séparer les plans images.

La figure 9 illustre un système d'imagerie 3D de l'invention. Le système d'imagerie I comprend un élément L apte à former une image I(Ob) d'un objet Ob et un dispositif d'imagerie Im conforme au dispositif de l'invention. L'élément L est, par exemple, une lentille. L'image I(Ob) est formée au niveau du dispositif d'imagerie Im selon différents plans objet.

## Revendications

1. Dispositif d'imagerie 3D comprenant une matrice (M) de photodétecteurs (2), **caractérisé en ce qu'**il comprend :
- une première couche de matériau (1) fixée sur une face de la matrice de photodétecteurs, la première couche de matériau (1) étant apte à réfléchir ou absorber une lumière incidente sur une quelconque de ses faces, une ouverture (3) étant pratiquée dans la première couche de matériau au niveau de chaque photodétecteur (2), et
- une deuxième couche de matériau (6), faite en matériau électriquement isolant, ayant une première face fixée sur la première couche de matériau (1), la deuxième couche de matériau (6) enrobant, dans sa masse, un ensemble de G guides d'onde (5), G étant un entier supérieur ou égal à 2, chaque guide d'onde(5) de l'ensemble de G guides d'ondes ayant une première extrémité affleurant sensiblement la première face de la deuxième couche de matériau et étant positionnée sensiblement en regard d'une ouverture (3) et une deuxième extrémité affleurant sensiblement une deuxième face de la deuxième couche de matériau (6) opposée à la première face, chaque deuxième extrémité formant un élément de capture pour une fraction d'une lumière incidente sur la deuxième face de la deuxième couche de matériau, les distances qui séparent les premières extrémités des deuxième extrémités de N guides d'onde distincts, N étant un nombre entier supérieur ou égal à 2 et inférieur ou égal à G, étant différentes les unes des autres.

2. Dispositif d'imagerie 3D selon la revendication 1, dans lequel les guides d'onde sont des nanofils.

3. Dispositif d'imagerie 3D selon la revendication 1 ou 2, dans lequel les G guides d'onde sont distribués au dessus de la face de la matrice de photodétecteurs de manière que Nd guides d'onde d'au moins un ensemble de Nd guides d'onde respectivement situés en regard de Nd ouvertures pratiquées au niveau de Nd photodétecteurs voisins formant une sous-matrice élémentaire de P lignes et Q colonnes, P et Q étant des entiers supérieurs ou égaux à 2 (P x Q = Nd), Nd étant un nombre supérieur ou égal à N, présentent N hauteurs distinctes prises par rapport à la première face de la deuxième couche de matériau.

4. Dispositif d'imagerie 3D selon la revendication 3 et qui comprend au moins deux ensembles distincts de Nd guides d'onde, dans lequel les Nd guides d'onde de chaque ensemble de Nd guides d'onde sont distribués selon un motif identique d'un ensemble de Nd guides d'onde à l'autre.

5. Dispositif d'imagerie 3D selon l'une quelconque des revendications 1 à 4, dans lequel la première couche de matériau (1) est une couche métallique qui réfléchit la lumière.

6. Procédé de fabrication de dispositif d'imagerie 3D, **caractérisé en ce qu'**il comprend :
- une étape de formation d'une première structure (D1) constituée d'une matrice (M) de photodétecteurs (2) sur une face de laquelle est déposée une première couche de matériau (1) apte à réfléchir ou absorber une lumière incidente sur une quelconque de ses faces, une ouverture (3) étant pratiquée dans la première couche de matériau au niveau de chaque photodétecteur (2),
- une étape de formation d'une deuxième structure (D2) constituée d'un substrat de type silicium sur isolant (S) sur lequel sont fixés des nanofils (5) enrobés dans une deuxième couche de matériau électriquement isolant (6), les nanofils étant répartis sur le substrat de type silicium sur isolant de façon sensiblement identique, à la façon dont sont répartis les ouvertures (3) pratiquées dans la première couche de matériau (1) et affleurant une face plane de la deuxième couche de matériau (6),
- une étape de report de la deuxième structure (D2) sur la première structure (D1) de sorte que les extrémités des nanofils qui affleurent la face plane de la deuxième couche de matériau soient placés en regard desdites ouvertures (3), et
- une étape de gravure du substrat de type silicium sur isolant et de la deuxième couche de matériau dans laquelle sont enrobés les nanofils pour, tout d'abord, supprimer le substrat de type silicium sur isolant puis, former N niveaux distincts de la deuxième couche de matériau dans laquelle sont enrobés les nanofils, les N niveaux distincts permettant de définir, respectivement, N nanofils différents ayant N hauteurs différentes les unes des autres, N étant un nombre entier supérieur ou égal à 2.

7. Procédé de fabrication de dispositif d'imagerie 3D selon la revendication 6, dans lequel l'étape de formation de la première structure (D1) comprend :
- une étape de dépôt, sur la face de la matrice (M) de photodétecteurs (2), de la première couche de matériau (1), et
- une étape de gravure de la première couche de matériau (1) pour former les ouvertures (3) pratiquée au niveau des photodétecteurs (2).

8. Procédé de fabrication de dispositif d'imagerie 3D selon la revendication 6 ou 7, dans lequel l'étape de formation de la deuxième structure (D2) comprend :
- une étape de dépôt, sur le substrat de type silicium sur isolant (S), d'une couche métallique,
- une étape de gravure de la couche métallique pour former un ensemble de plots métalliques (4) répartis, sur le substrat de type silicium sur isolant (S), d'une façon sensiblement identique à la façon dont sont répartis les ouvertures (3) sur la matrice de photodétecteurs,
- une étape de croissance de nanofils (5) à partir des plots métalliques (4),
- une étape de dépôt de la deuxième couche de matériau (6) sur le substrat de type silicium sur isolant (S) de façon à enrober l'ensemble des nanofils (5), et
- une étape de planarisation de la deuxième couche de matériau (6) pour supprimer les plots métalliques (5) et rendre plane la surface de la deuxième couche (6) de telle sorte que les nanofils affleurent ladite surface.

9. Système d'imagerie 3D comprenant un élément apte à former une image en volume (I(ob)) d'un objet tridimensionnel (Ob), **caractérisé en ce qu'**il comprend, en outre, un dispositif d'imagerie 3D selon l'une quelconque des revendications 1 à 5 placé au niveau de l'image en volume.

10. Système d'imagerie 3D selon la revendication 9 dans lequel l'élément apte à former une image en volume d'un objet tridimensionnel est une lentille.
